# EUROPÄISCHE PATENTSCHRIFT

(11) **EP 3 519 914 B1**
(45) Veröffentlichungstag und Bekanntmachung des Hinweises auf die Patenterteilung: **28.08.2019**
(21) Anmeldenummer: 17783410.8
(22) Anmeldetag: 25.09.2017
(51) Int. Cl.: G06F 1/20, H05K 7/20

(54) **LICHTSTELLPULT MIT KÜHLEINRICHTUNG**
LIGHT CONTROL CONSOLE HAVING A COOLING DEVICE
PUPITRE D'ÉCLAIRAGE POURVU D'UN DISPOSITIF DE REFROIDISSEMENT

(30) Priorität: 30.09.2016 DE 102016118598
(43) Veröffentlichungstag der Anmeldung: 07.08.2019
(73) Patentinhaber: MA Lighting Technology GmbH, 97297 Waldbüttelbrunn (DE)
(72) Erfinder: ADENAU, Michael, 97082 Würzburg (DE)
(74) Vertreter: advotec.
(86) Internationale Anmeldenummer: PCT/EP2017/074190
(87) Internationale Veröffentlichungsnummer: WO 2018/060123

(56) Entgegenhaltungen:
- EP-A1- 2 950 625
- EP-A2- 2 293 658
- DE-A1-102014 113 888
- DE-B3-102007 058 166
- US-A1- 2006 011 330
- US-A1- 2009 009 966

## Beschreibung

Die Erfindung betrifft ein Lichtstellpult zur Steuerung einer Beleuchtungsanlage mit einer Kühleinrichtung zur aktiven Kühlung der im Innenraum des Konsolengehäuses angeordneten Bauteile nach dem Oberbegriff des Anspruchs 1.

Gattungsgemäße Lichtstellpulte, wie sie beispielsweise aus der DE 10 2007 058 166 B3 bekannt sind, dienen zur Steuerung von Beleuchtungsanlagen, wie sie beispielsweise in Theatern oder Konzertbühnen zum Einsatz kommen. Diese Beleuchtungsanlagen umfassen regelmäßig eine Vielzahl von Beleuchtungseinrichtungen, beispielsweise Bühnenscheinwerfern, wobei die Beleuchtungseinrichtungen vielfach auch noch für sich genommen zwischen einer Vielzahl von Beleuchtungszuständen, beispielsweise unterschiedlichen Farben, umgeschaltet werden können. Diese unterschiedlichen Beleuchtungszustände der jeweils an das Lichtstellpult angeschlossenen Beleuchtungseinrichtungen können durch programmierte Parameter im Beleuchtungsprogramm des Lichtstellpults gesteuert werden. Übliche Beleuchtungsanlagen können dabei bis zu mehreren Tausend Beleuchtungseinrichtungen umfassen. Um derartige komplexe Beleuchtungsanlagen steuern zu können, sind die gattungsgemäßen Lichtstellpulte mit zumindest einem Digitalprozessor ausgestattet, der eine digitale Daten- und Signalverarbeitung erlaubt. Zur Speicherung der Steuerdaten ist regelmäßig ein Digitalspeicher vorgesehen, der es insbesondere ermöglicht, Beleuchtungsprogramme zu speichern bzw. zu archivieren. Zum Schutz der elektrischen und elektronischen Bauteile des Lichtstellpults sind die entsprechenden Komponenten in ein Konsolengehäuse eingebaut, das die elektrischen und elektronischen Komponenten des Lichtstellpults nach außen hin abschirmt. Die elektrischen und elektronischen Bauteile des Lichtstellpults im Konsolengehäuse erzeugen eine erhebliche Abwärme, die durch passive Kühlung, beispielsweise durch einfache Konvektion, nicht in ausreichendem Maße abgeführt werden kann. Um Beschädigungen der elektrischen und elektronischen Bauteile des Lichtstellpults durch Überhitzung zu vermeiden, sind aus dem Stand der Technik Lichtstellpulte bekannt, die mit einer Kühleinrichtung aktiv gekühlt werden können. Möglicherweise dient dazu ein Lüfter, mit dem Kühlluft aus der Umgebung angesaugt und durch das Konsolengehäuse hindurchgefördert werden kann. Im Unterschied zu üblichen Rechnereinheiten, beispielsweise Personal Computern, besteht dabei bei den Lichtstellpulten die Problematik, dass diese eine Vielzahl von Gehäusedurchbrüchen aufweisen, um beispielsweise die Schieberegler aus dem Inneren des Gehäuses zu dem Bedienfeld an der Oberseite des Konsolengehäuses hindurchzuführen. Diese Vielzahl von Durchbrüchen sorgt dafür, dass die Kühlluft an einer Vielzahl von Durchlassöffnungen aus dem Innenraum des Konsolengehäuses austritt, so dass eine gezielte Führung des Kühlluftstroms weitgehend unmöglich gemacht wird. Um dennoch für eine ausreichende Kühlung der im Innenraum des Konsolengehäuses angeordneten Bauteile zu sorgen, ist es deshalb erforderlich sehr große Mengen von Kühlluft durch das Konsolengehäuse durchzuführen. Die Förderung der zur Kühlung des Lichtstellpults mit seinen Durchbrüchen erforderlichen großen Mengen von Kühlluft führt jedoch zu erheblichen Nachteilen. So werden durch die für die Förderung der Kühlluft eingesetzten Lüfter bei entsprechend hohen Förderleistungen unerwünschte Geräusche erzeugt, die den Bedienkomfort für den Benutzer erheblich einschränken. In technischer Hinsicht ist die Durchförderung großer Mengen von Kühlluft, die aus der Umgebung abgesaugt wird, nachteilig, da zusammen mit der Kühlluft große Mengen von Staub und Schwebpartikeln in das Konsolengehäuse eingesaugt werden. Dieser Staub und die Schwebteile können sich dann auf den empfindlichen elektronischen Bauteilen im Innenraum des Konsolengehäuses absetzen und dort zu Störungen bzw. zu Bauteilausfällen führen. Insbesondere die Schieberegler sind gegenüber dem Eintrag von Staubpartikeln sehr empfindlich.

Aus der EP 2 293 658 A2 ist eine Kühleinrichtung für eine Rechnereinheit bekannt, bei der die Kühlung mittels eines Rekuperators erfolgt. US 2006/011330 A1 offenbart eine Kühlvorrichtung für einen Prozessor, mit einem Strömungskanal, wobei im Strömungskanal zumindest ein Luftfilterelement angeordnet ist, mit dem Staubpartikel aus der Kühlluft gefiltert werden können. DE 10 2014 113888 A1 offenbart ein elektronisches Gerät mit einem Steuergerät und einem Temperatursensor. Der Temperatursensor wird verwendet, um die Temperatur der elektronischen Vorrichtung zu erfassen. Das Steuergerät wird verwendet, um eine Luftquellentemperatur oder eine Strömungsgeschwindigkeit oder eine Rotationsgeschwindigkeit der Luftstrom-Beschleunigungseinrichtung gemäß einer erfassten Temperatur zu steuern.

Ausgehend von diesem Stand der Technik ist es Aufgabe der vorliegenden Erfindung ein neues Lichtstellpult mit modifizierter Kühlung vorzuschlagen, mit dem die oben beschriebenen Nachteile des Stands der Technik bei der Nutzung von Lichtstellpulten vermieden werden.

Diese Aufgabe wird durch ein Lichtstellpult nach der Lehre des Anspruchs 1 gelöst.

Vorteilhafte Ausführungsformen der Erfindung sind Gegenstand der Unteransprüche.

Das erfindungsgemäße Lichtstellpult beruht auf dem Grundgedanken, dass zur Kühlung der Bauteile im Innenraum des Konsolengehäuses ein Rekuperator zur indirekten Wärmeübertragung vorgesehen ist. Bei dem Rekuperator handelt es sich um einen Wärmetauscher, mit dem Wärmeenergie von der Primärseite des Rekuperators an die Sekundärseite des Rekuperators ohne Stoffaustausch übertragbar ist. Auf diese Weise kann der Rekuperator an seiner Primärseite Abwärme aus dem Innenraum des Konsolengehäuses aufnehmen und an seine Sekundärseite übertragen. Sekundärseitig wird der Rekuperator dann selbst von einem Kühlmedium durchströmt oder umströmt, um die Abwärme auf das Kühlmedium zu übertragen und mittels einer entsprechenden Kühlmediumsströumung abzuführen. Im Ergebnis wird also dadurch eine Kühlung erreicht, bei der der Wärmestrom vom Kühlmittelstrom entkoppelt wird. Stattdessen wird die Abwärme ohne Stoffaustausch durch Wärmeleitung im Rekuperator von der im Innenraum des Konsolengehäuses angeordneten Primärseite auf die mit dem Kühlmedium gekühlte Sekundärseite übertragen. Das Kühlmedium selbst muss dann nicht mehr durch den Innenraum des Konsolengehäuses durchgeleitet werden, so dass die aus dem Stand der Technik bekannten Nachteile im Hinblick auf die Geräuschentwicklung und den Staubeintrag entsprechend verringert bzw. ganz vermieden werden.

Wie bereits bekannt enthält die Kühlluft Staub und Schmutzpartikel, die auch bei der sekundärseitigen Kühlung des Rekuperators zu unerwünschten Folgen führen können. Beispielsweise kann der Staub sich im Strömungskanal und hier insbesondere in Kühlrissen absetzen und dadurch den Strömungswiderstand erhöhen bzw. die Kühlwirkung herabsetzen. Um diese unerwünschten Folgen des Einsaugens von Staub und Schutzpartikeln zu vermeiden, ist es erfindungsgemäß vorgesehen, im Strömungskanal zumindest ein Luftfilterelement anzuordnen, mit dem Staubpartikel aus der Kühlluft herausgefiltert werden können.

Welche Art von Kühlmedium zur Kühlung der Sekundärseite des Rekuperators eingesetzt wird, ist grundsätzlich beliebig. Die einfachste Bauform ergibt sich, wenn als Kühlmedium Kühlluft verwendet wird, die problemlos aus der Umgebungsatmosphäre des Lichtstellpults entnommen und nach Kühlung des Rekuperators dorthin zurückgeführt werden kann. Soweit der Rekuperator im Innenraum des Konsolengehäuses eingebaut ist, ist es vorteilhaft, wenn das Konsolengehäuse eine Einströmöffnung und eine Ausströmöffnung für die Kühlluft aufweist. Zwischen Einströmöffnung und Ausströmöffnung erstreckt sich dann ein gekapselter Strömungskanal, entlang dem die Kühlluft die Sekundärseite des Rekuperators durchströmen bzw. umströmen kann. Durch die Kapselung des Strömungskanals wird verhindert, dass Kühlluft in unerwünschter Weise unkontrolliert in den Innenraum des Konsolengehäuses eindringt und dort zu unerwünschten Staubablagerungen führt.

In welcher Weise die Kühlluft durch den Strömungskanal hindurchgefördert wird, ist grundsätzlich beliebig. Besonders einfach kann dies mittels eines elektrisch angetriebenen Lüfters bzw. durch mehrere solcher Lüfter bewirkt werden. Durch Antrieb des elektrischen Lüfters kann die Kühlluft aus der Umgebungsluft in die Einströmöffnung eingefördert, durch den Strömungskanal durchgefördert und an der Ausströmöffnung ausgefördert werden.

Der Wirkungsgrad der Kühlwirkung, die mit der Kühlluftströmung bei einer bestimmten Strömungsleistung erreicht werden kann, lässt sich durch Anordnung von Luftleitflächen im Strömungskanal signifikant erhöhen. Insbesondere im Bereich der Ansaugöffnung des elektrisch angetriebenen Lüfters ist die Anordnung eines Luftleitbleches vorteilhaft. Durch teilweise Abdeckung der Ansaugöffnung lässt sich nämlich die mit dem Lüfter angesaugte Luftmenge bei gleichbleibender elektrischer Antriebsleistung signifikant erhöhen.

Eine besonders hohe Kühlleistung wird erfindungsgemäß dadurch erreicht, dass das Wärmeüberträgerelement in der Art eines abgeschlossenen Wärmerohrs, nämlich in der Art einer so genannten "Heatpipe" ausgebildet ist. Bei diesen Wärmerohren bzw. Heatpipes handelt es sich um Wärmeüberträgerelemente, bei denen das abgeschlossene Wärmerohr mit einem Arbeitsmedium, insbesondere Wasser oder Ammoniak, gefüllt ist. Der Druck des Arbeitsmediums im Wärmerohr ist dabei so gewählt, dass das Arbeitsmedium das Volumen des Wärmerohrs zu einem Teil in flüssigem und zum anderen Teil in dampfförmigem Zustand ausfüllt. Die Wärmeübertragung innerhalb des Wärmerohrs erfolgt dabei durch Nutzung von Verdampfungswärme des im Wärmerohr zirkulierenden Arbeitsmediums. Der Wärmewiderstand dieser abgeschlossenen Wärmerohre (Heatpipes) ist sehr gering, so dass eine sehr effektive Kühlung der die Abwärme erzeugenden Bauteile durch Wärmeübertragung auf den Kühlkörper des Rekuperators erreicht werden kann. Um die Effektivität und Prozesssicherheit der Kühleinrichtung im Lichtstellpult zu erhöhen, ist es erfindungsgemäß vorgesehen, dass die Kühleinrichtung zumindest einen Temperatursensor umfasst, der mit einer Temperatursteuereinrichtung zusammenarbeitet. Der Temperatursensor kann dann im Innenraum des Konsolengehäuses und/oder im Strömungskanal des Kühlmediums angeordnet werden und dort Temperaturdaten aufnehmen. Die Kühlleistung des Rekuperators kann dann von der Temperatursteuereinrichtung in Abhängigkeit der gemessenen Sensordaten des Temperatursensors gesteuert oder geregelt werden. Auf diese Weise kann die jeweils aufgebrachte Kühlleistung der Kühleinrichtung auf die aktuellen Randbedingungen, beispielsweise die Leistungsaufnahme der elektronischen Bauteile im Konsolengehäuse oder die jeweils herrschende Außentemperatur, abgestimmt werden.

Weiter ist es erfindungsgemäß vorgesehen, dass die Kühlleistung des Rekuperators durch Änderung der Antriebsleistung des elektrisch angetriebenen Lüfters in Abhängigkeit der Sensordaten des Temperatursensors gesteuert oder geregelt wird, um dadurch die Geräuschentwicklung auf ein unumgängliches Maß zu begrenzen.

Um die Konvektionsströmung im Konsolengehäuse zu erhöhen, ist im Konsolengehäuse erfindungsgemäß zumindest ein Lüfter vorgesehen, der die Luft innerhalb des Konsolengehäuses umwälzt.

Die konstruktive Ausbildung des Rekuperators ist grundsätzlich beliebig. Gemäß einer ersten besonders einfachen Bauweise des Rekuperators ist es vorgesehen, dass dazu eine Kühlplatte aus einem Material mit hoher Wärmeleitfähigkeit verwendet wird. Primärseitig wird dann ein Abwärme erzeugendes Bauteil, beispielsweise das Netzteil des Lichtstellpults, auf dieser Kühlplatte befestigt. Sekundärseitig ist die Kühlplatte dann an einer Stelle angeordnet, an der sie vom Kühlmedium umströmt wird, um die in der Kühlplatte von der Primärseite zur Sekundärseite weitergeleitete Abwärme an das Kühlmedium zu übertragen und mit dem Kühlmittelstrom abzuführen.

Im Hinblick auf eine höhere Kühlleistung kann der Rekuperator alternativ zur Verwendung einer Kühlplatte auch in der Art eines Kühlkörpers mit mehreren sekundärseitig angeordneten Kühlrippen ausgebildet sein. Die Kühlrippen werden zur sekundärseitigen Kühlung des Kühlkörpers vom Kühlmedium umströmt, wobei durch die durch die Kühlrippen entsprechend erhöhte Kühlfläche die Kühlleistung des Rekuperators signifikant erhöht werden kann.

Zur besonders einfachen Kühlung des Innenraums des Konsolengehäuses kann der Rekuperator dann primärseitig eine Kühlfläche aufweisen, an der die im Innenraum des Konsolengehäuses befindliche Luft abgekühlt wird. Auf diese Weise ergibt sich im Innenraum des Konsolengehäuses eine zumindest geringfügige Konvektionsströmung, bei der die an den Bauteilen durch die Abwärme erwärmte Luft zur Kühlfläche des Kühlkörpers strömt, hier abgekühlt wird und dann zurück zu den die Abwärme produzierenden Bauteilen strömt. Bei elektrischen Bauteilen, die große Mengen von Abwärme produzieren, beispielsweise bei den Prozessoren der Hauptplatine bzw. den
Prozessoren der Graphikkarte, reicht eine Abfuhr der Wärme durch Konvektionsströmung innerhalb des Konsolengehäuses vielfach nicht aus. Um die Abwärme mit ausreichender Geschwindigkeit von diesen Bauteilen abführen zu können, kann an der Primärseite des Kühlkörpers das erste Ende eines Wärmeübertragungselements mit geringem Wärmeleitwiderstand angeordnet werden, wobei das zweite Ende des Wärmeübertragerelements an dem die Abwärme erzeugenden Bauteil im Innenraum des Konsolengehäuses angeordnet ist. Auf diese Weise kann dann die Abwärme durch das Wärmeübertragungselement ohne Stoffaustausch an den Kühlkörper weitergeleitet werden. Zur Wärmeleitung zwischen dem die Abwärme erzeugenden Bauteil und dem Kühlkörper dient dann also nicht mehr ausschließlich die im Innenraum des Konsolengehäuses enthaltene Luft, sondern das Wärmeübertragungselement, das aufgrund seiner hohen Wärmeleitfähigkeit für eine entsprechende Kühlung des Bauteils durch Abfuhr der Abwärme an den Kühlkörper sorgt.

Um den Rekuperator kostengünstig herstellen zu können und zugleich eine hohe Wärmeleitung zwischen Primärseite und Sekundärseite zu erreichen, ist es besonders vorteilhaft, wenn die Kühlplatte und/oder der Kühlkörper aus einem Metall mit geringem Wärmeleitwiderstand herstellt ist. Insbesondere Kupfer, Aluminium oder Messing eignen sich zur Herstellung des Rekuperators.

Eine Ausführungsform der Erfindung ist in den Zeichnungen schematisch dargestellt und wird nachfolgend beispielhaft erläutert.

Es zeigen:
- **Fig. 1**: ein erfindungsgemäßes Lichtstellpult in perspektivischer Ansicht von vorne;
- **Fig. 2**: das Lichtstellpult gemäß Fig. 1 in perspektivischer Ansicht von hinten;
- **Fig. 3**: das Lichtstellpult gemäß Fig. 1 mit teilweise aufgebrochen dargestelltem Bedienfeld in perspektivischer Ansicht von vorne;
- **Fig. 4**: die Kühleinrichtung des Lichtstellpults gemäß Fig. 1 in perspektivischer Ansicht von vorne;
- **Fig. 5**: die Kühleinrichtung gemäß Fig. 4 in vergrößerter perspektivischer Ansicht;
- **Fig. 6**: die Kühleinrichtung gemäß Fig. 5 nach Entfernen eines Teils der Strömungskanäle unter Darstellung des ersten Rekuperators und des zweiten Rekuperators in perspektivischer Ansicht von vorne;
- **Fig. 7**: den zweiten Rekuperator der Kühleinrichtung gemäß Fig. 6 in perspektivischer Einzeldarstellung.

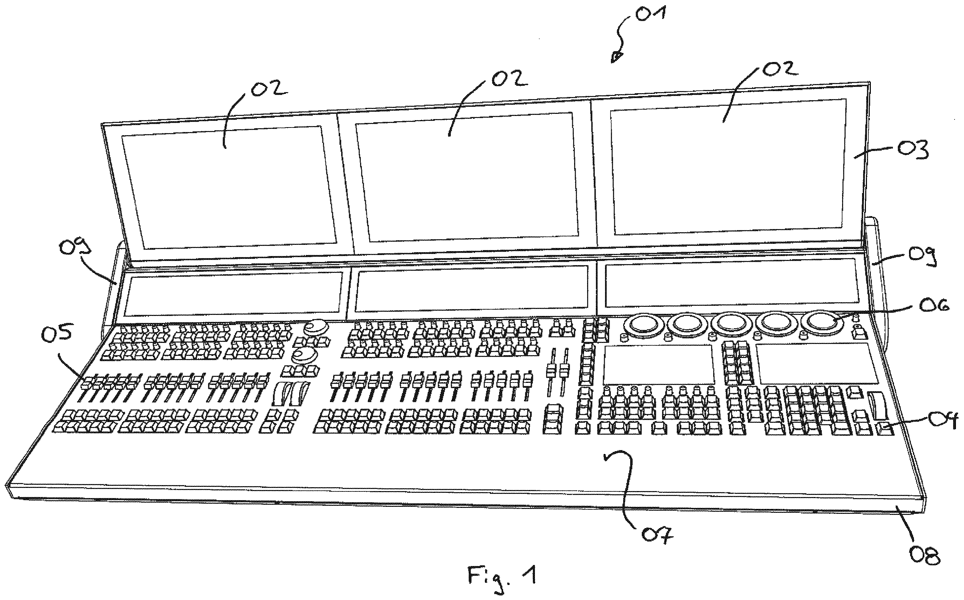

**Fig. 1** zeigt in perspektivischer Ansicht ein erfindungsgemäßes Lichtstellpult 01 zur Programmierung und Steuerung einer Beleuchtungsanlage. Das Lichtstellpult 01 ist mit drei Bildschirmen 02 zur Anzeige von diversen Menüs für den Benutzer ausgestattet. Die Bildschirme 02 sind ihrerseits in einem Bildschirmgehäuse 03 eingebaut.

Zur Eingabe von Stellbefehlen ist am Lichtstellpult 01 eine Vielzahl von Tastern 04, Schiebereglern 05 und Drehreglern (Encodern) 06 in einem Bedienfeld 07 an der Oberseite eines Konsolengehäuses 08 vorgesehen. Zur verstellbaren Lagerung des Bildschirmgehäuses 03 am Konsolengehäuse 08 dienen ein linker und ein rechter Schwenkarm 09. Im Innenraum des Konsolengehäuses 08 ist eine Kühleinrichtung zur Kühlung der im Konsolengehäuse verbauten elektrischen und elektronischen Bauteile vorhanden, die nachfolgend noch näher erläutert werden.

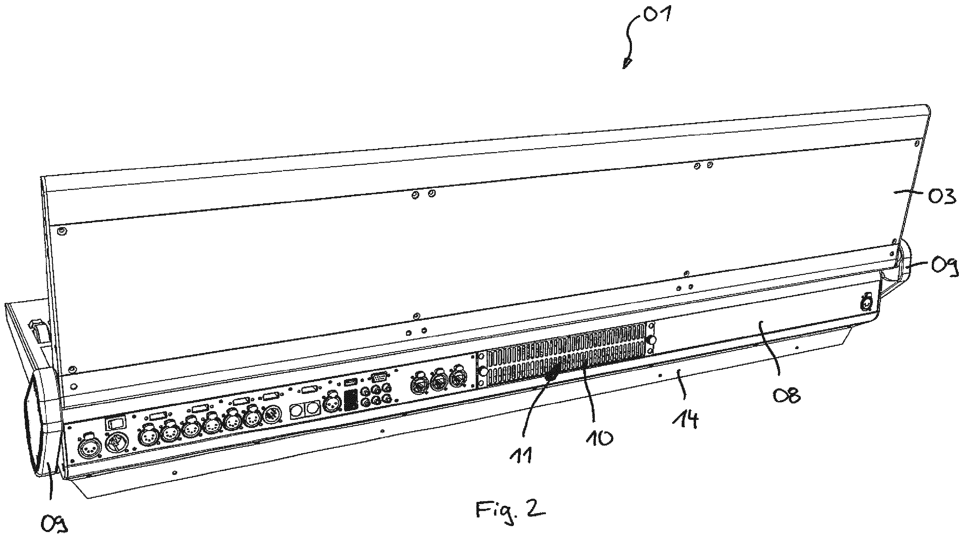

**Fig. 2** zeigt das Lichtstellpult 01 in Ansicht von hinten. Auf der Rückseite des Konsolengehäuses 08 befindet sich eine mit einem Schutzgitter 10 teilweise abgedeckte Einströmöffnung 11, durch die Kühlluft aus der Umgebung des Lichtstellpults 01 angesaugt werden kann.

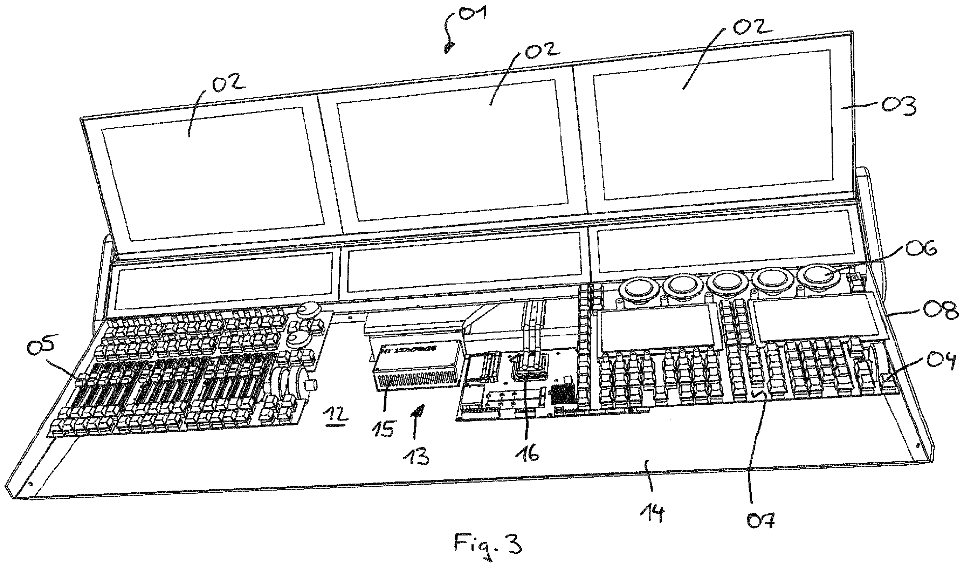

**Fig. 3** zeigt das Lichtstellpult 01 mit teilweise aufgebrochen dargestelltem Bedienfeld 07, um dadurch den Blick in den Innenraum 12 des Konsolengehäuses zumindest teilweise freizugeben. Dabei sind von den Bauteilen im Innenraum 12 des Konsolengehäuses 01 nur die Teile dargestellt, die zum Verständnis der Erfindung erforderlich sind. Hinter der Einströmöffnung 11 ist eine Kühleinrichtung 13 angeordnet, mit der die im Inneren 12 anfallende Abwärme ohne Durchleitung von Kühlluft durch den Innenraum 12 abgeführt werden kann.

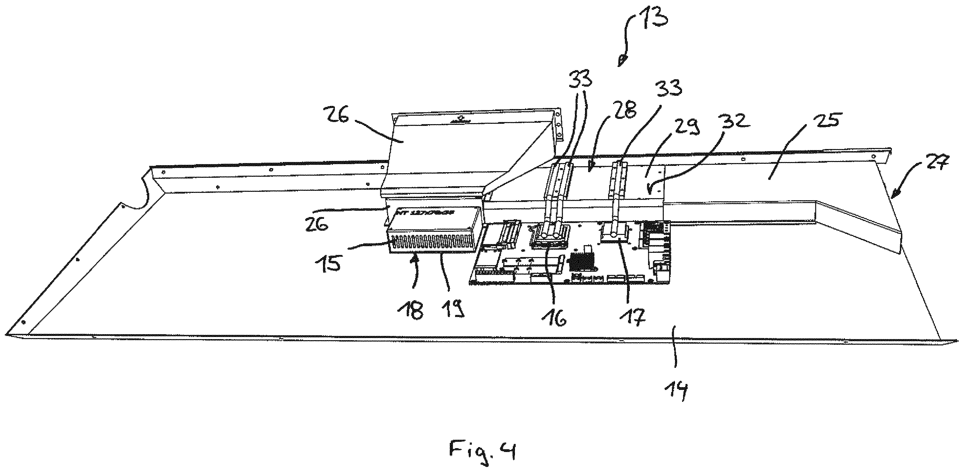

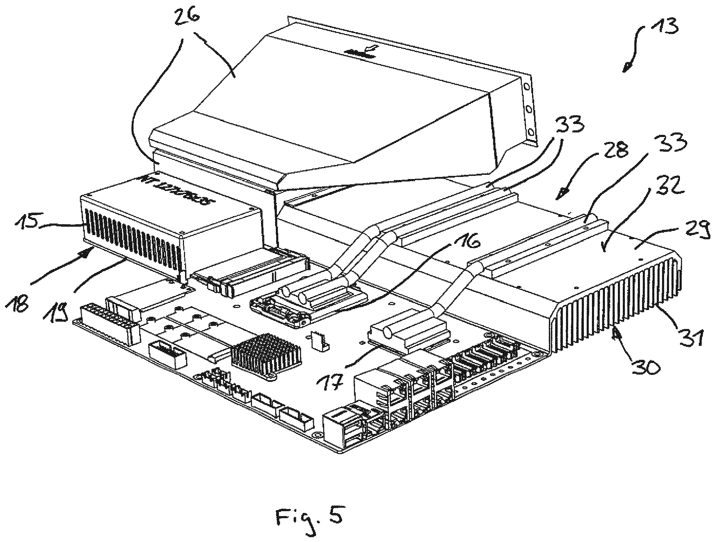

**Fig. 4 bis Fig. 6** zeigen die Kühleinrichtung 13 nach Entfernung des Bildschirmgehäuses 03 und nach Entfernung des Oberteils des Konsolengehäuses 08. Die Kühleinrichtung 13 ist dabei auf dem Unterteil 14 des Konsolengehäuses 08 befestigt. Die Kühleinrichtung 13 dient insbesondere der Ableitung der von einem Netzteil 15 und zwei Prozessoren 16 und 17 erzeugten Abwärme.

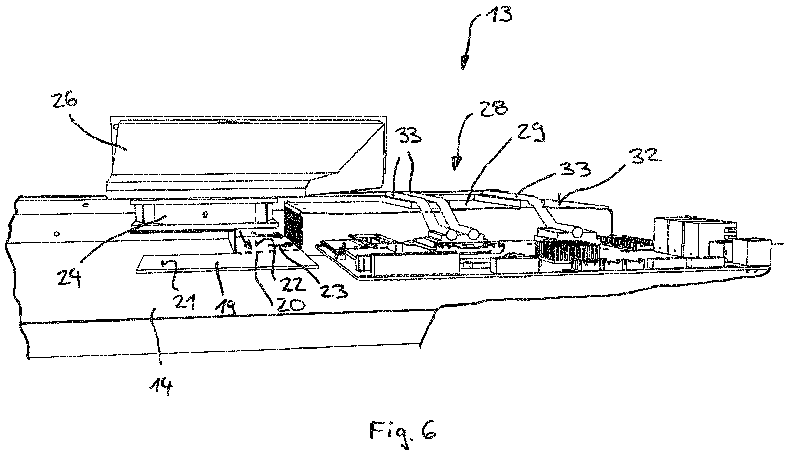

Um die Abwärme des Netzteils 15 abzuführen, ist das Netzteil 15 auf einem ersten Rekuperator 18, nämlich einer Kühlplatte aus Kupfer, befestigt. Die Anordnung des ersten Rekuperators 18 ist dabei insbesondere aus der Darstellung in Fig. 6 ersichtlich. Die Kühlplatte 19 ist L-förmig geschnitten. Eine Strichlinie 20 teilt dabei die Oberseite der Kühlplatte 19 in die Primärseite 21 und die Sekundärseite 22. Auf der Primärseite 21 ist das Netzteil 15 befestigt, so dass die vom Netzteil 15 erzeugte Abwärme primärseitig auf die Kühlplatte 19 übertragen wird. Aufgrund der hohen Wärmeleitfähigkeit der Kühlplatte 19, die aus Kupfer besteht, fließt die Abwärme dann durch die Kühlplatte 19 zur Sekundärseite 22, an deren Oberseite ein Kühlluftstrom 23 vorbeigeführt wird. Die Kühlluft 23 wird dazu von einem Lüfter 24 durch die Einströmöffnung 11 angesaugt und durch gekapselte Strömungskanäle 25 und 26 durchgefördert. Die Strömungskanäle 25 und 26 bestehen aus Luftführungsblechen, die luftdicht miteinander und dem Konsolengehäuse 08 so verbunden sind, dass die Kühlluft 23 nicht aus dem Strömungskanal 26 in den Innenraum 12 austreten kann. Stattdessen wird die gesamte Kühlluft 23, die an der Einströmöffnung 11 angesaugt wird, zur Ausströmöffnung 27 gefördert, wo sie wieder in die Umgebung ausgeblasen wird.

Nach Überströmen der Sekundärseite 22 der Kühlplatte 19 strömt die Kühlluft 23 sekundärseitig in einen zweiten Rekuperator 28 der Kühleinrichtung 13 ein. Der Rekuperator 28 ist in der Art eines Kühlkörpers 29 ausgebildet, der an seiner Sekundärseite 30 eine Vielzahl von Kühlrippen 31 aufweist. Die Kühlluft 23 strömt an den Kühlrippen 31 vorbei, um diese zu kühlen. Die Primärseite 32 des Kühlkörpers 29 weist somit eine gekühlte Außenseite auf, an der die im Innenraum 12 befindliche Luft im Konsolengehäuse 08 abgekühlt werden kann, um auf diese Weise die im Innenraum 12 befindlichen Bauteile des Lichtstellpults 01 zu kühlen. Außerdem ist die Primärseite 32 des Kühlkörpers 29 mittels mehrerer Wärmerohre 33 mit den Prozessoren 16 und 17 verbunden, so dass die an den Prozessoren 16 und 17 anfallende Abwärme durch Wärmeleitung in den Wärmerohren 33 direkt an die gekühlte Primärseite 32 geleitet werden kann.

Mittels eines nicht dargestellten Temperatursensors wird die Innentemperatur im Innenraum 12 des Lichtstellpults 01 gemessen und mittels einer Temperaturregeleinrichtung wird die Antriebsleistung des Lüfters 24 zur Aufrechterhaltung einer zuverlässigen Höchsttemperatur im Innenraum 12 geregelt.

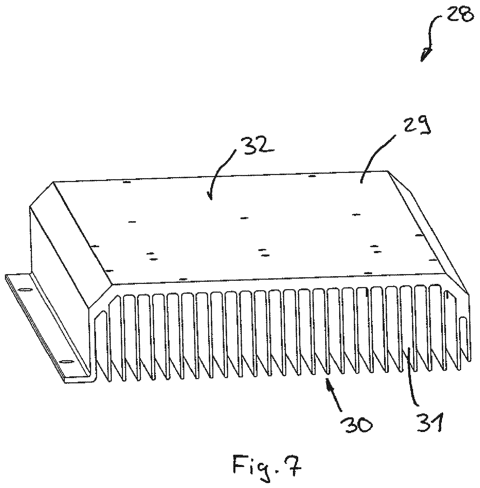

Fig. 7 zeigt den zweiten Rekuperator der Kühleinrichtung gemäß Fig. 6 in perspektivischer Einzeldarstellung.

## Patentansprüche

1. Lichtstellpult (01) zur Steuerung einer Beleuchtungsanlage, wobei im Lichtstellpult (01) digitale Stellbefehle erzeugt werden, die über Datenverbindungen an die Beleuchtungseinrichtungen der Beleuchtungsanlage übertragen werden können, wobei das Lichtstellpult (01) zumindest einen Digitalprozessor (16, 17) und zumindest einen Digitalspeicher zur Erzeugung, Verwaltung und Speicherung der Stellbefehle umfasst, und wobei der Digitalprozessor (16, 17) und der Digitalspeicher in einem Konsolengehäuse (08) angeordnet sind, und wobei an der Oberseite des Konsolengehäuses (08) ein Bedienfeld (07) mit zumindest einem Bedienelement, insbesondere einem Taster (04) und/oder zumindest einem Schieberegler (05) und/oder zumindest einem Drehregler (06) vorgesehen ist, an dem Bedienbefehle vom Benutzer eingegeben werden können, und wobei das Lichtstellpult (01) zumindest einen Bildschirm (02) umfasst, und wobei das Lichtstellpult (01) zumindest eine Kühleinrichtung (13) umfasst, mit der Bauteile im Innenraum (12) des Konsolengehäuses (08) aktiv gekühlt werden können,
**dadurch gekennzeichnet,**
**dass** die Kühleinrichtung (13) zumindest einen Rekuperator (18, 28) zur indirekten Wärmeübertragung umfasst, wobei der Rekuperator (18, 28) auf seiner Primärseite (21, 32) Abwärme aufnimmt und durch Wärmeleitung ohne Stoffaustausch an seine Sekundärseite (22, 30) überträgt, und wobei der Rekuperator (18, 28) sekundärseitig von einem Kühlmedium (23) in einem Strömungskanal durchströmt oder umströmt werden kann, um die Abwärme auf das Kühlmedium (23) zu übertragen, wobei im Strömungskanal (25, 26) zumindest ein Luftfilterelement angeordnet ist, mit dem Staubpartikel aus der Kühlluft (23) gefiltert werden können, und wobei das Wärmeüberträgerelement (33) in der Art eines abgeschlossenen Wärmerohrs, Heatpipe, ausgebildet ist, wobei das Wärmerohr mit einem Arbeitsmedium, insbesondere Wasser oder Ammoniak, gefüllt ist, und wobei das Arbeitsmedium das Volumen des Wärmerohrs zu einem Teil in flüssigem und zum anderen Teil in dampfförmigem Zustand ausfüllt, und wobei die Wärmeübertragung im Wärmerohr unter Nutzung von Verdampfungswärme des im Wärmerohr zirkulierenden Arbeitsmediums erfolgt, und wobei die Kühleinrichtung (13) zumindest einen Temperatursensor umfasst, der im Innenraum (12) des Konsolengehäuses (08) und/oder im Strömungskanal (25, 26) angeordnet ist, wobei die Kühlleistung der Kühleinrichtung (13) mit Rekuperator (18, 28) in Abhängigkeit der gemessenen Sensordaten des Temperatursensors von einer Temperatursteuereinrichtung gesteuert oder geregelt wird, und wobei die Kühlleistung der Kühleinrichtung (13) mit Rekuperator (18, 28) durch Änderung der Antriebsleistung des elektrisch angetriebenen Lüfters (24) in Abhängigkeit der Sensordaten des Temperatursensors gesteuert oder geregelt wird, und wobei im Innenraum des Konsolengehäuses ein elektrisch angetriebener Umwälzlüfter vorgesehen ist, mit dem die Luft im Innenraum des Konsolengehäuses umgewälzt wird.

2. Lichtstellpult nach Anspruch 1,
**dadurch gekennzeichnet,**
**dass** im Lichtstellpult (01) der Strömungskanal als ein zum Innenraum (12) des Konsolengehäuses (08) hin gekapselter Strömungskanal (25, 26) vorgesehen ist, in dem Kühlluft (23) von einer Einströmöffnung (11) im Konsolengehäuse (08) zu einer Ausströmöffnung (27) im Konsolengehäuse (08) gefördert werden kann und dabei den Rekuperator (18, 28) sekundärseitig durchströmt oder umströmt.

3. Lichtstellpult nach Anspruch 1 oder 2,
**dadurch gekennzeichnet,**
**dass** im Strömungskanal (25, 26) zumindest ein elektrisch angetriebener Lüfter (24) vorgesehen ist, mit dem Umgebungsluft als Kühlluft in die Einströmöffnung (11) eingefördert, durch den Strömungskanal (25, 26) durchgefördert und an der Ausströmöffnung (27) ausgefördert werden kann.

4. Lichtstellpult nach einem der Ansprüche 1 bis 3,
**dadurch gekennzeichnet,**
**dass** im Strömungskanal (25, 26) zumindest ein Luftleitblech angeordnet ist.

5. Lichtstellpult nach Anspruch 4,
**dadurch gekennzeichnet,**
**dass** das Luftleitblech an der Ansaugöffnung des elektrisch angetriebenen Lüfters (24) angeordnet ist, wobei das Luftleitblech die Ansaugöffnung teilweise abdeckt.

6. Lichtstellpult nach einem der Ansprüche 1 bis 5,
**dadurch gekennzeichnet,**
**dass** der Rekuperator (18) in der Art einer Kühlplatte (19) ausgebildet ist, auf der primärseitig ein Abwärme erzeugendes Bauteil, insbesondere ein Netzteil (15), befestigt ist, wobei die Kühlplatte (19) sekundärseitig vom Kühlmedium (23) gekühlt wird.

7. Lichtstellpult nach einem der Ansprüche 1 bis 5,
**dadurch gekennzeichnet,**
**dass** der Rekuperator (28) in der Art eines Kühlkörpers (29) mit mehreren sekundärseitig angeordneten Kühlrippen (31) ausgebildet ist, wobei die Kühlrippen (31) vom Kühlmedium (23) umströmt werden können.

8. Lichtstellpult nach Anspruch 7,
**dadurch gekennzeichnet,**
**dass** die Primärseite (32) des Kühlkörpers (29) eine im Innenraum (12) des Konsolengehäuses (08) angeordnete Kühlfläche bildet.

9. Lichtstellpult nach einem der Ansprüche 7 bis 8,
**dadurch gekennzeichnet,**
**dass** an der Primärseite (32) des Kühlkörpers (29) das erste Ende eines Wärmeüberträgerelements (33) mit geringem Wärmeleitwiderstand angeordnet ist, wobei das zweite Ende des Wärmeüberträgerelements (33) an einem Abwärme erzeugenden Bauteil im Innenraum (12) des Konsolengehäuses (08), insbesondere einem Prozessor (16, 17), angeordnet ist, und wobei die Abwärme des Bauteils durch das Wärmeüberträgerelement (33) ohne Stoffaustausch an den Kühlkörper (29) weitergeleitet werden kann.

10. Lichtstellpult nach einem der Ansprüche 1 bis 9,
**dadurch gekennzeichnet,**
**dass** der Rekuperator (18, 28), insbesondere die Kühlplatte (19) und/oder der Kühlkörper (19), aus einem Metall mit geringem Wärmeleitwiderstand, insbesondere aus Kupfer, Aluminium oder Messing, hergestellt ist.

## Claims

1. A lighting control console (01) for controlling a lighting system, digital adjusting commands being generated in the lighting control console (01), which commands can be transmitted to the lighting devices of the lighting system via data links, said lighting control console (01) comprising at least one digital processor (16, 17) and at least one digital memory for generating, managing and storing the adjusting commands, and said digital processor (16, 17) and said digital memory being disposed in a console housing (08), and a control panel (07) having at least one control element, in particular a key button (04) and/or at least one slide control (05) and/or at least one rotary control (06), being provided at the upper side of the console housing (08), which control panel allows users to enter control commands, and said lighting control console (01) comprising at least one screen (02), and said lighting control console (01) comprising at least one cooling device (13), with the aid of which components within the interior (12) of the console housing (08) can actively be cooled,
**characterised in that**
the cooling device (13) comprises at least one recuperator (18, 28) for indirect heat transfer, said recuperator (18, 28), on its primary side (21, 32), absorbing waste heat and transferring it to its secondary side (22, 30) by way of heat conduction without any exchange of material, and said recuperator (18, 28), on its secondary side, being configured to have a cooling agent (23) flow through it or circulate around it in a flow channel in order to transfer the waste heat onto the cooling agent (23), at least one air filter element being disposed in the flow channel (25, 26), with the aid of which dust particles can be filtered from the cooling air (23), and the heat transfer element (33) being embodied in the manner of a closed heat pipe, said heat pipe being filled with a working medium, in particular with water or with ammonia, and said working medium filling the volume of the heat pipe partly in a liquid state and partly in a vapour state, and said heat transfer being effected in the heat pipe using vaporisation heat of the working medium circulating in the heat pipe, and said cooling device (13) comprising at least one temperature sensor that is disposed in the interior (12) of the console housing (08) and/or in the flow channel (25, 26), the cooling capacity of the cooling device (13) having the recuperator (18, 28) being controlled by a temperature control device as a function of the measured sensor data of the temperature sensor, and said cooling capacity of the cooling device (13) having the recuperator (18, 28) being controlled by changing the drive power of the fan (24) that is electrically driven as a function of the sensor data of the temperature sensor, and a circulating fan that is electrically driven being provided in the interior of the console housing, with the aid of which circulating fan the air in the interior of the console housing is circulated.

2. The lighting control console according to claim 1,
**characterised in that**
in the lighting control console (01), the flow channel is provided as a flow channel (25, 26) which is sealed toward the interior (12) of the console housing (08), and in which cooling air (23) can be conveyed from an influx opening (11) in the console housing (08) to an outlet opening (27) in the console housing (08), the cooling air flowing through or circulating around the recuperator (18, 28) on its secondary side in this process.

3. The lighting control console according to claim 1 or 2,
**characterised in that**
in the flow channel (25, 26), at least one electrically driven fan (24) is provided, with the aid of which the ambient air as cooling air can be conveyed into the influx opening (11), conveyed through the flow channel (25, 26) and conveyed out at the outlet opening (27).

4. The lighting control console according to any one of the claims 1 to 3,
**characterised in that**
at least one air deflector is disposed in the flow channel (25, 26).

5. The lighting control console according to claim 4,
**characterised in that**
the air deflector is disposed at the intake opening of the electrically driven fan (24), said air deflector partially covering the intake opening.

6. The lighting control console according to any one of the claims 1 to 5,
**characterised in that**
the recuperator (18) is embodied in the manner of a cooling plate (19), on which a component that generates waste heat, in particular a power supply pack (15), is fastened on the primary side, said cooling plate (19) being cooled on the secondary side by the cooling agent (23).

7. The lighting control console according to any one of the claims 1 to 5,
**characterised in that**
the recuperator (28) is embodied in the manner of a heat sink (29) having several cooling fins (31) that are disposed on the secondary side, said cooling fins (31) being configured to have said cooling agent (23) circulate around them.

8. The lighting control console according to claim 7,
**characterised in that**
the primary side (32) of the heat sink (29) forms a cooling surface that is disposed in the interior (12) of the console housing (08).

9. The lighting control console according to any one of the claims 7 to 8,
**characterised in that**
the first end of a heat transfer element (33) having a low thermal resistivity is disposed on the primary side (32) of the heat sink (29), the second end of said heat transfer element (33) being disposed on a component that generates waste heat, in the interior (12) of the console housing (08), in particular on a processor (16, 17), and wherein the waste heat of the component can be passed on to the heat sink (29) through the heat transfer element (33) without any exchange of material.

10. The lighting control console according to any one of the claims 1 to 9,
**characterised in that**
the recuperator (18, 28), in particular the cooling plate (19) and/or the heat sink (19), is produced from a metal having a low thermal resistivity, in particular from copper, aluminium or brass.

## Revendications

1. Pupitre de commande d'éclairage (01) pour commander un système d'éclairage, des instructions de réglage numériques qui peuvent être transmises aux dispositifs d'éclairage du système d'éclairage par des liaisons de données étant générées dans le pupitre de commande d'éclairage (01), ledit pupitre de commande d'éclairage (01) comprenant au moins un processeur numérique (16, 17) et au moins une mémoire numérique pour générer, gérer et stocker les instructions de réglage, et ledit processeur numérique (16, 17) et ladite mémoire numérique étant disposés dans un boîtier de console (08), et un panneau de commande (07) ayant au moins un élément de commande, en particulier un bouton poussoir (04) et/ou au moins un curseur (05) et/ou au moins un bouton rotatif (06), étant prévu sur le côté supérieur du boîtier de console (08), les utilisateurs pouvant entrer des instructions de commande audit panneau de commande, et ledit pupitre de commande d'éclairage (01) comprenant au moins un écran (02), et ledit pupitre de commande d'éclairage (01) comprenant au moins un dispositif de refroidissement (13) à l'aide duquel des composants situés dans l'intérieur (12) du boîtier de console (08) peuvent être refroidis activement,
**caractérisé en ce que**
le dispositif de refroidissement (13) comprend au moins un récupérateur (18, 28) assurant un transfert de chaleur indirect, ledit récupérateur (18, 28), sur son côté primaire (21, 32), absorbant de la chaleur perdue et la transférant à son côté secondaire (22, 30) moyennant une conduction de chaleur sans transfert de matière, et un agent de refroidissement (23), dans un canal d'écoulement, pouvant couler à travers ou autour dudit récupérateur (18, 28) sur le côté secondaire de sorte que la chaleur perdue soit transférée à l'agent de refroidissement (23), au moins un élément de filtre à air étant disposé dans le canal d'écoulement (25, 26), à l'aide duquel élément de filtre des particules de poussière peuvent être filtrées de l'air de refroidissement (23), et l'élément de transfert de chaleur (33) étant réalisé á la manière d'un caloduc fermé (heatpipe), ledit caloduc étant rempli d'un milieu de travail, en particulier de l'eau ou de l'ammoniac, et ledit milieu de travail comblant le volume du caloduc pour partie à l'état liquide et pour partie à l'état de vapeur, et ledit transfert de chaleur étant effectué dans le caloduc en utilisant de la chaleur de vaporisation du milieu de travail circulant dans le caloduc, et ledit dispositif de refroidissement (13) comprenant au moins un capteur de température qui est disposé dans l'intérieur (12) du boîtier de console (08) et/ou dans le canal d'écoulement (25, 26), la capacité de refroidissement du dispositif de refroidissement (13) ayant le récupérateur (18, 28) étant commandée ou réglée par un dispositif de commande de température en fonction des données de capteur mesurées du capteur de température, et ladite capacité de refroidissement du dispositif de refroidissement (13) ayant le récupérateur (18, 28) étant commandée ou réglée en changeant la capacité d'entraînement du ventilateur (24) qui est entraîné par voie électrique en fonction des données de capteur du capteur de température, et un ventilateur d'air circulé qui est entraîné par voie électrique étant prévu dans l'intérieur du boîtier de console, à l'aide duquel l'air dans l'intérieur du boîtier de console est circulé.

2. Pupitre de commande d'éclairage selon la revendication 1,
**caractérisé en ce que**
dans le pupitre de commande d'éclairage (01), le canal d'écoulement est prévu comme un canal d'écoulement (25, 26) qui est encapsulé vers l'intérieur (12) du boîtier de console (08) et dans lequel de l'air de refroidissement (23) peut être transporté d'une ouverture d'entrée d'écoulement (11) dans le boîtier de console (08) vers une ouverture de sortie d'écoulement (27) dans le boîtier de console (08), coulant à travers ou autour du récupérateur (18, 28) sur le côté secondaire en faisant cela.

3. Pupitre de commande d'éclairage selon la revendication 1 ou 2,
**caractérisé en ce que**
dans le canal d'écoulement (25, 26), au moins un ventilateur (24) est prévu qui est entraîné par voie électrique, et à l'aide duquel de l'air de l'environnement comme l'air de refroidissement peut être importé dans l'ouverture d'entrée d'écoulement (11), transporté à travers le canal d'écoulement (25, 26) et expulsé à l'ouverture de sortie d'écoulement (27).

4. Pupitre de commande d'éclairage selon l'une quelconque des revendications 1 à 3,
**caractérisé en ce**
**qu'**au moins un déflecteur d'air est disposé dans le canal d'écoulement (25, 26).

5. Pupitre de commande d'éclairage selon la revendication 4,
**caractérisé en ce que**
le déflecteur d'air est disposé à l'ouverture d'aspiration du ventilateur (24) qui est entraîné par voie électrique, ledit déflecteur d'air couvrant l'ouverture d'aspiration en partie.

6. Pupitre de commande d'éclairage selon l'une quelconque des revendications 1 à 5,
**caractérisé en ce que**
le récupérateur (18) est réalisé á la manière d'une plaque de refroidissement (19), sur laquelle un composant qui produit de la chaleur perdue, en particulier une alimentation électrique (15), est attaché sur le côté primaire, ladite plaque de refroidissement (19) étant refroidie par l'agent de refroidissement (23) sur le côté secondaire.

7. Pupitre de commande d'éclairage selon l'une quelconque des revendications 1 à 5,
**caractérisé en ce que**
le récupérateur (28) est réalisé à la manière d'un refroidisseur (29) ayant plusieurs ailettes de refroidissement (31) qui sont disposées sur le côté secondaire, l'agent de refroidissement (23) pouvant couler autour lesdites ailettes de refroidissement (31).

8. Pupitre de commande d'éclairage selon la revendication 7,
**caractérisé en ce que**
le côté primaire (32) du refroidisseur (29) constitue une surface de refroidissement qui est disposée dans l'intérieur (12) du boîtier de console (08).

9. Pupitre de commande d'éclairage selon l'une quelconque des revendications 7 à 8,
**caractérisé en ce que**
la première extrémité d'un élément de transfert de chaleur (33) ayant une inertie thermique basse est disposée au côté primaire (32) du refroidisseur (29), la deuxième extrémité de l'élément de transfert de chaleur (33) étant disposée à un composant qui produit de la chaleur perdue, dans l'intérieur (12) du boîtier de console (08), en particulier à un processeur (16, 17), et la chaleur perdue du composant pouvant être acheminée au refroidisseur (29) moyennant l'élément de transfert de chaleur (33) sans transfert de matière.

10. Pupitre de commande d'éclairage selon l'une quelconque des revendications 1 à 9,
**caractérisé en ce que**
le récupérateur (18, 28), en particulier la plaque de refroidissement (19) et/ou le refroidisseur (19), est fabriqué à base d'un métal ayant une inertie thermique basse, en particulier à base du cuivre, de l'aluminium ou du laiton.
